# EUROPÄISCHE PATENTSCHRIFT

(11) **EP 3 405 975 B1**
(45) Veröffentlichungstag und Bekanntmachung des Hinweises auf die Patenterteilung: **15.04.2020**
(21) Anmeldenummer: 17700920.6
(22) Anmeldetag: 10.01.2017
(51) Int. Cl.: H01L 23/467, H01L 23/473, H01L 23/50, H01L 25/07

(54) **VORRICHTUNG ZUR KÜHLUNG MINDESTENS EINER STROMSCHIENE UND KORRESPONDIERENDE LEISTUNGSSCHALTUNG**
DEVICE FOR COOLING AT LEAST ONE BUS BAR AND CORRESPONDING POWER CIRCUIT
DISPOSITIF POUR REFROIDIR AU MOINS UNE BARRE OMNIBUS ET CIRCUIT DE PUISSANCE CORRESPONDANT

(30) Priorität: 20.01.2016 DE 102016200724
(43) Veröffentlichungstag der Anmeldung: 28.11.2018
(73) Patentinhaber: Robert Bosch GmbH, 70442 Stuttgart (DE)
(72) Erfinder: PROEPPER, Thomas, 72793 Pfullingen (DE)
(86) Internationale Anmeldenummer: PCT/EP2017/050403
(87) Internationale Veröffentlichungsnummer: WO 2017/125283

(56) Entgegenhaltungen:
- EP-A1- 1 672 692
- WO-A1-2015/165800
- DE-A1-102011 075 731
- JP-A- 2006 339 239

## Beschreibung

Die Erfindung geht aus von einer Vorrichtung zur Kühlung mindestens einer Stromschiene nach Gattung des unabhängigen Patentanspruchs 1. Gegenstand der vorliegenden Erfindung ist auch eine Leistungsschaltung nach der Gattung des unabhängigen Patentanspruchs 9 mit mindestens einer solchen Vorrichtung zur Kühlung mindestens einer Stromschiene.

Aus Leistungstransistoren, Lotverbindern, Stromschienen, Kondensatoren und Drosseln bestehende leistungselektronische Baugruppen werden in der Regel auf geschichteten DBC-Schaltungsträgern (DBC: Directly Bonded Copper) oder auch Hochstromleiterplatten aufgebaut. Insbesondere für Leistungsschaltungen mit hohen und höchsten Verlustleistungen, die mit geringem thermischen Durchgangswiderstand an potentialfreien Wärmesenken entwärmt werden, werden solche DBC-Schaltungsträger eingesetzt. Der keramische Träger einer DBC-Baugruppe liegt im Wärmepfad und hat eine wesentlich geringere thermische Leitfähigkeit als Kupfer. Zur besseren Spreizung des Wärmestroms ist zwischen Keramikträger und Wärmesenke in der Regel eine sich nahezu über den gesamten Wärmestromquerschnitt erstreckende Kupferschicht aufgebracht. Diese Kupferschicht wird in der Regel mittels Wärmeleitpaste oder Folie auf die Wärmesenke aufgebracht, die etwa aus Aluminium oder (seltener) aus Kupfer besteht. Die Wärmeleitpaste lässt laterale thermomechanische Dehnungen des DBC-Schaltungsträgers zu und erlaubt die Aufbringung der Kupferschicht auf Materialien mit erheblich verschiedenen thermischen Ausdehnungskoeffizienten. Aufgrund ihrer geringen Wärmeleitfähigkeit stellt die Wärmeleitpaste oder Wärmeleitfolie nach der Keramik eine weitere thermische Barriere dar, die ein signifikantes Temperaturgefälle im Wärmepfad hervorrufen kann.

Der Verringerung dieses Temperaturgefälles mittels Ausbildung eines möglichst kleinen Spaltmaßes zwischen der Kupferschicht und der Wärmsenke sind einerseits wegen vorgegebener Fertigungs- und Fügetoleranzen der Baugruppe, andererseits kraft thermischer Oberflächenwiderstände zwischen unebenen Fügeflächen mit typischen technischen Rauigkeiten Grenzen gesetzt. Diese Kontaktwiderstände können insbesondere bei Verwendung körniger Wärmeleitpasten oder steifer Wärmeleitfolien und Ausbildung geringer Spaltweiten kleiner 200 µm dominant werden.

Aus der DE 10 2013 203 532 A1 ist eine Bauteilkühlung eines auf einer Grundplatte sitzenden elektrischen Leistungsbauteils in Form eines Chips bekannt. Der Chip ist über eine DBC-Schicht sowie eine Lotschicht auf der Grundplatte angeordnet. Diese Grundplatte weist an der dem Chip abgewandten Rückseite einen Kühlkörper auf, der über eine Wärmeleitpaste in thermischen Kontakt mit der Grundplatte ist und über Schrauben mit der Grundplatte verbunden ist. Über als Stromschienen ausgeführte Anschlüsse wird der Chip mit externen Komponenten elektrisch verbunden. Diese als Stromschienen ausgeführten Anschlüsse sind im Querschnitt und durch Materialauswahl für einen Wärmetransport entsprechend gestaltet. Die als Stromschienen ausgeführten Anschlüsse weisen einen aus Kunststoff gefertigten Grundkörper auf, in welchem zwei Leiterbahnen und drei Kühlmittelkanäle angeordnet sind. Die von einem Kühlmittel durchflossenen Kühlmittelkanäle sind mit einem Kühlsystem verbunden und führen die Wärmenergie des Chips ab.

Aus der DE 10 2004 018 469 B3 ist eine Leistungshalbleiterschaltung bekannt, welche ein Leistungshalbleitermodul umfasst und als flache Baugruppe ausgebildet ist, indem mindestens ein elektronisches Bauelement auf einem Substrat angeordnet und über eine oberseitige Kontaktfläche mit einer Anschlussfläche einer Folie kontaktiert ist. Zudem umfasst die Leistungshalbleiterschaltung eine stromzuführende und/oder abführende Verschienung, auf deren einen Deckschiene das Leistungshalbleitermodul angeordnet ist, und eine Kühleinrichtung, welche in die Verschienung integriert ist.

Aus der WO 2015/165800 A1 ist eine Schaltungsanordnung bekannt, welche ein Trägerteil, ein Leistungsbauelement, einen Kühlkanal zum Durchleiten eines Kühlmittels, eine Stromschiene zum Leiten eines Stroms zu dem Leistungsbauelement, die auf dem Trägerteil angeordnet ist und einen Bereich aufweist, der mit einer ersten Oberfläche und einer zweiten, der ersten Oberfläche entgegengesetzten Oberfläche von dem Trägerteil weg in den Kühlkanal ragt, wobei das Leistungsbauelement auf der ersten Oberfläche des Bereichs angeordnet und mit dem Bereich elektrisch leitend und mechanisch verbunden ist.

Aus der DE 10 2011 075 731 ist ein Leistungshalbleitermodul mit mindestens zwei Halbleitern bekannt, die in einem Modulgehäuse angeordnet sind. Das Modul umfasst mindestens einen ersten und einen zweiten Leistungshalbleiter mit jeweils zwei Leistungsanschlüssen und mindestens einen ersten und einen zweiten Kühlkörper. Der erste Kühlkörper ist zur Abfuhr der Wärme des ersten Leistungshalbleiters und der zweite Kühlkörper ist zur Abfuhr der Wärme des zweiten Leistungshalbleiters vorgesehen, wobei die Kühlkörper galvanisch voneinander getrennt sind. Zudem ist ein erster Leistungsanschluss des ersten Leistungshalbleiters mit dem ersten Kühlkörper elektrisch leitend verbunden, und ein zweiter Leistungsanschluss des zweiten Leistungshalbleiters ist mit dem zweiten Kühlkörper elektrisch leitend verbunden. Zudem weist der erste Kühlkörper einen ersten Anschluss zur Verbindung des ersten Kühlkörpers mit einem ersten Potential auf, und der zweite Kühlkörper weist einen zweiten Anschluss zur Verbindung des zweiten Kühlkörpers mit einem zweiten, vom ersten unterschiedlichen Potential auf.

Aus der EP 1 672 692 A1 ist ein Leistungshalbleitermodul mit einer gattungsgemäßen Vorrichtung zur Kühlung mindestens einer Stromschiene, mit einem Grundkörper und mindestens einer Kühlrippe bekannt. Hierbei kann die mindestens eine Stromschiene als Kühlrippe ausgebildet werden. Zudem ist mindestens ein Kühlkörper als Strömungskammer ausgebildet, welche eine korrespondierende Stromschiene zumindest teilweise aufnimmt und deren Wandungen einen Strömungskanal bilden, wobei eine innerhalb der Strömungskammer erzwungene Fluidströmung Wärmenergie von der in die Strömungskammer ragenden Oberfläche der als Kühlrippe ausgebildeten Stromschiene aufnimmt und abführt.

### Offenbarung der Erfindung

Die Vorrichtung zur Kühlung mindestens einer Stromschiene mit den Merkmalen des unabhängigen Patentanspruchs 1 und die Leistungsschaltung mit den Merkmalen des unabhängigen Patentanspruchs 9 haben den Vorteil, dass im Gegensatz zu einer Leistungsschaltung mit einem herkömmlichen Kühlkörper, welcher die von lokalen Verlustleistungsquellen eingetragene Wärme spreizt und etwa über Kühlrippen an eine erzwungene Luftströmung abgibt, die Abwärme der mindestens einen Stromschiene und/oder der Leistungsschaltung überwiegend durch die thermisch und elektrisch impedanzarm ausgelegte mindestens eine als Kühlrippe ausgebildete Stromschiene fließt, deren Oberflächen der erzwungenen entwärmenden Fluidströmung ausgesetzt sind.

Ausführungsformen der vorliegenden Erfindung stellen eine Vorrichtung zur Kühlung mindestens einer Stromschiene mit einem Grundkörper und mindestens einer Kühlrippe zur Verfügung. Hierbei ist die mindestens eine Stromschiene als Kühlrippe ausgebildet, wobei mindestens ein Kühlkörper als Strömungskammer ausgebildet ist, welche eine korrespondierende Stromschiene zumindest teilweise aufnimmt und deren Wandungen einen Strömungskanal bilden, wobei eine innerhalb der Strömungskammer erzwungene Fluidströmung Wärmenergie von der in die Strömungskammer ragenden Oberfläche der als Kühlrippe ausgebildeten Stromschiene aufnimmt und abführt.

Zudem wird eine Leistungsschaltung vorgeschlagen, welche mindestens einen Leistungshalbleiter und mindestens zwei Stromschienen, welche unterschiedliche elektrische Potentiale aufweisen, und eine Vorrichtung zur Kühlung mindestens einer Stromschiene umfasst. Hierbei ragen die als Kühlrippen ausgebildeten mindestens zwei Stromschienen vereinzelt und galvanisch getrennt zumindest teilweise in jeweils einen als Strömungskammer ausgebildeten Kühlkörper hinein.

Die in die kühlende Fluidströmung hineinragenden Oberflächen von mehreren Stromschienen können in vereinzelten Strömungskanälen untergebracht werden, wobei die Stromschienen und die die Stromschienen umstreichenden Kühlströmungen mittels elektrisch isolierenden Strömungskammerwandungen voneinander getrennt werden können. Im Inneren dieser Strömungskammern können sich entlang der Stromschienen Kanalströmungen ausbilden, welche von einem oder mehreren Gebläsen oder auch von natürlicher Konvektion angetrieben werden können. Die Ein- und Austrittsöffnungen dieser Strömungskammern können von den umschlossenen Stromschienen soweit abgesetzt werden, dass im Fall einer Beaufschlagung mit elektrisch schwach leitfähigen Aerosolströmungen wie Nassdampf (Nebel), salzhaltigem Spritz- oder Regenwasser in allen elektrischen Betriebszuständen eine sichere galvanische Trennung der Potentialunterschiede aufweisenden Stromschienen gewährleistet ist. An den Aus- und Eintrittsöffnungen der Strömungskammern sind Tropfenfänger und Tropfenabscheider angebracht, welche die von Kohäsionskräften hervorgerufene Koagulation elektrisch leitfähiger Flüssigkeitstropfen zu Rinnsalen auf den Kanalinnenwandungen und damit elektrische Nebenschlüsse zwischen Stromschienen verhindert können, welche unterschiedliche Potentiale führen. Geeignete Ausführungen solcher Tropfenabscheider sind beispielsweise in Verbindung mit elektronischen Heißfilmluftmassenmessern (HFM) bekannt, welche im Luftsystem von Kraftfahrzeugmotoren eingesetzt werden können.

Aufgrund der hohen thermischen Leitfähigkeit eines elektrischen Leiters aus Kupfer oder Aluminium, können die Stromschienen bei technisch vorteilhafter elektrothermischer Auslegung auch als thermische Stromschienen mit geringem Wärmewiderstand wirken und die Verlustleistung der Leistungsschaltung unmittelbar durch hohe Wärmeströme an deren Strömungsumgebung ableiten. Zum Betrieb in aggressiven Strömungsumgebungen, wie hochkonzentrierten Salznebeln, eignen sich korrosionsbeständige Stromschienen aus vernickeltem, verzinntem oder passiviertem Kupfer oder hartanodisiertem Aluminium. Am Eintritt und/oder Austritt der Strömungskammern angeordnete Tropfenabscheider können die elektrische Potentialtrennung zwischen den Stromschienen auch in korrosiven Strömungsumgebungen wirksam verstärken.

Die thermische Kapazität des Systems kann mit geringem thermischen Durchgangswiderstand an die Verlustleistungsquellen der Leistungsschaltung angebunden werden, was insbesondere der Wärmespreizung und Wärmepufferung im Fall transienter elektrothermischer Lastprofile mit ausgeprägten Lastspitzen zugutekommt.

Die Stromschienen können mit einem elektrisch leitenden Grundkörper der elektronischen Leistungsschaltung betriebsfest und galvanisch getrennt verklebt werden. Somit kann der Grundkörper sowohl als elektrischer Rückleiter ausgeführt werden als auch potentialfrei bleiben. Die Stromschienen können im Fall eines als elektrischer Rückleiter ausgebildeten metallischen Grundkörpers bzw. Gehäuses eine geringe Schleifen- und Streuinduktivität ausbilden. Werden die Stromschienen mit genügend hoher Wärmekapazität sowie geringem Wärmewiderstand zur in der korrespondierenden Strömungskammer erzwungenen Fluidströmung hin ausgelegt, so kann auf einen schweren metallischen Grundkörper verzichtet und die Leistungsschaltung mit einem Grundkörper aus Kunststoff oder einem anderen elektrisch nicht leitenden Werkstoff ausführt werden. Darin können Abschnitte der Stromschienen beispielsweise mittels eines Kunststoff-Spritzgießvorgangs oder mittels einer Fließ-Press-Verbindung stoffschlüssig in das Material des Grundkörpers eingeschlossen werden.

Zusätzlich oder alternativ sind die Strömungskammerwandungen profiliert ausgeführt und bewirken entlang der Stromschiene eine stetige Verjüngung des Strömungskanals und beschleunigen die Fluidströmung zur Hinterkante der Stromschiene. Dadurch kann in vorteilhafte Weise ein reibungsbedingter Impulsverlust verringern und die Ablösung der oberflächennahen Laminarströmung von der Stromschienenoberfläche vermieden werden. Zudem kann an einer Vorderkante und/oder einer Hinterkante der in die Strömungskammer ragenden Stromschiene ein aerodynamisch widerstandsarmer Verdrängungskörper angeordnet werden, welcher eine weitgehend laminare Umströmung der in die Strömungskammer ragenden Oberfläche der Stromschiene bewirken kann. Die Ablösung der laminaren Grenzschicht kommt erst nahe der Hinterkante des stromabwärts liegenden Verdrängungskörpers zustande. Folglich bilden sich durch den Verdrängungskörper in der wandnahen Kanalströmung in vorteilhafter Weise eine gleichmäßig dünne turbulent-viskose Grenzschicht und ein höherer Wärmestrom in die Kanalströmung aus, als bei stumpfen Kanten. Die Verdrängungskörper können beispielsweise aus einem thermoplastischen Kunststoff bestehen, welcher vorzugsweise in einem Spritzgießverfahren auf die Vorder- und Hinterkante der Stromschienen stoffschlüssig aufgebracht werden kann. Dies erfolgt vorzugweise im selben Fertigungsschritt zusammen mit der Fertigung der Strömungskammerwandungen.

Durch die in den abhängigen Ansprüchen aufgeführten Maßnahmen und Weiterbildungen sind vorteilhafte Verbesserungen der im unabhängigen Patentanspruch 1 angegebenen Vorrichtung zur Kühlung mindestens einer Stromschiene und der im unabhängigen Patentanspruch 9 angegebenen Leistungsschaltung möglich.

In weiterer vorteilhafter Ausgestaltung der erfindungsgemäßen Vorrichtung zur Kühlung mindestens einer Stromschiene kann der mindestens eine Kühlkörper als separates Bauteil gefertigt und beispielsweise mittels Kleben und/oder Schrauben mit dem Grundkörper verbunden werden. Alternativ kann der mindestens eine Kühlkörper an den Grundkörper angeformt werden, d.h. einstückig mit dem Grundkörper ausgebildet werden.

In vorteilhafter Ausgestaltung der erfindungsgemäßen Leistungsschaltung können die Stromschienen jeweils zwei Schenkel aufweisen, wobei ein erster Schenkel der jeweiligen Stromschiene in den Grundkörper der Kühlvorrichtung eingebettet und parallel zu einer Aufbauebene der Leistungsschaltung in einem Schaltungsraum verlaufen kann. Zudem kann ein zweiter Schenkel der jeweiligen Stromschiene als Kühlrippe senkrecht zum ersten Schenkel ausgebildet werden und in die korrespondierende Strömungskammer des Kühlkörpers ragen.

Bei einem elektrisch leitenden Grundkörper kann der zweite Schenkel durch eine Öffnung im Grundkörper in die korrespondierende Strömungskammer ragen Hierbei kann der zweite Schenkel über eine Siegelschicht von den Wandungen der korrespondierende Strömungskammer getrennt werden.

In weiterer vorteilhafter Ausgestaltung der erfindungsgemäßen Leistungsschaltung kann ein erster Anschluss des mindestens einen Leistungshalbleiters direkt mit dem ersten Schenkel einer der Stromschienen verbunden werden. Ein zweiter Anschluss des mindestens einen Leistungshalbleiters kann über einen Bonddraht mit dem ersten Schenkel einer der Stromschienen verbunden werden. Dadurch kann die Abwärme des mindestens einen Leistungshalbleiters über die mindestens eine als Kühlrippe ausgebildete Stromschiene in die umgebende Kühlströmung abgeleitet werden.

In weiterer vorteilhafter Ausgestaltung der erfindungsgemäßen Leistungsschaltung können eine erste Stromschiene mit einem ersten elektrischen Potential, eine zweite Stromschiene mit einem zweiten elektrischen Potential und eine dritte Stromschiene mit einem dritten elektrischen Potential verbunden werden, wobei diese elektrischen Potentiale voneinander verschieden sein können. Die Leistungsschaltung kann beispielsweise als B2-Brücke ausgeführt werden, welche ein Paar in Reihe geschalteter Leistungstransistoren umfasst, an deren Mittenabgriff eine pulsweitenmodulierte Phasenspannung zur Speisung etwa einer induktiven Last erregt wird. Daher kann die erste Stromschiene mit einem Lowside-Potential einer Festspannungsquelle oder eines Zwischenkreises eines Pulswechselrichters verbunden werden, und an der zweiten Stromschiene kann ein Phasenpotential der B2-Brücke abgegriffen werden. Die dritte Stromschiene kann mit einem Highside-Potential der Festspannungsquelle oder des Zwischenkreises des Pulswechselrichters verbunden werden. Der Drain- oder Kollektoranschluss eines ersten Leistungshalbleiters kann über eine Lötschicht direkt mit dem ersten Schenkel der ersten Stromschiene verbunden werden, und ein Source- oder Emitteranschluss des ersten Leistungshalbleiters kann über einen Bonddraht mit dem ersten Schenkel der zweiten Stromschiene verbunden werden. Zudem kann der Drain- oder Kollektoranschluss eines zweiten Leistungshalbleiters über eine Lötschicht direkt mit dem ersten Schenkel der zweiten Stromschiene verbunden werden, und ein Source- oder Emitteranschluss des zweiten Leistungshalbleiters kann über einen Bonddraht mit dem ersten Schenkel der dritten Stromschiene verbunden werden.

In weiterer vorteilhafter Ausgestaltung der erfindungsgemäßen Leistungsschaltung kann in einem Hohlraum des Grundkörpers zwischen dem zweiten Schenkel der ersten Stromschiene und dem zweiten Schenkel der dritten Stromschiene ein Elektrodenstapel eines ungehäusten Folienkondensators angeordnet werden, dessen erste Kontaktschicht an den zweiten Schenkel der ersten Stromschiene und dessen zweite Kontaktschicht an den zweiten Schenkel der dritten Stromschiene anschließen kann, wobei eine Siegelschicht den Elektrodenstapel von den Strömungskammern abtrennt. Dadurch kann der ungehäuste Folienkondensator in vorteilhafter Weise elektrisch impedanzarm an die zweiten Stromschienenschenkel anschließen, was insbesondere im Betrieb als Zwischenkreis-Kapazität eines Pulswechselrichters von Bedeutung ist. Die Verbindung kann beispielsweise mittels Schweißen oder Löten hergestellt werden. Da die ohmsche Verlustleistungsdichte im Elektrodenstapel unmittelbar an den Anschlussschichten am größten ist, fließt die Abwärme des Elektrodenstapels in vorteilhafter Weise mit geringem thermischen Widerstand in die zweiten Stromschienenschenkel, an deren Oberflächen die Abwärme von den Fluidströmungen in den korrespondierenden Strömungskammern abgetragen wird.

Ausführungsbeispiele der Erfindung sind in der Zeichnung dargestellt und werden in der nachfolgenden Beschreibung näher erläutert. In der Zeichnung bezeichnen gleiche Bezugszeichen Komponenten bzw. Elemente, die gleiche bzw. analoge Funktionen ausführen.

### Kurze Beschreibung der Zeichnungen

Fig. 1 zeigt eine schematische Schnittdarstellung eines ersten Ausführungsbeispiels einer erfindungsgemäßen Leistungsschaltung mit einem Ausführungsbeispiel einer erfindungsgemäßen Vorrichtung zur Kühlung mindestens einer Stromschiene.
Fig. 2 zeigt eine schematische Schnittdarstellung eines zweiten Ausführungsbeispiels einer erfindungsgemäßen Leistungsschaltung mit einem Ausführungsbeispiel einer erfindungsgemäßen Vorrichtung zur Kühlung mindestens einer Stromschiene.
Fig. 3 zeigt eine schematische Schnittdarstellung eines dritten Ausführungsbeispiels einer erfindungsgemäßen Leistungsschaltung mit einem Ausführungsbeispiel einer erfindungsgemäßen Vorrichtung zur Kühlung mindestens einer Stromschiene.
Fig. 4 zeigt eine schematische Schnittdarstellung eines ersten Ausführungsbeispiels eines Kühlkörpers der erfindungsgemäßen Vorrichtung zur Kühlung mindestens einer Stromschiene aus Fig. 1 bis 3.
Fig. 5 zeigt eine schematische Schnittdarstellung eines zweiten Ausführungsbeispiels eines Kühlkörpers der erfindungsgemäßen Vorrichtung zur Kühlung mindestens einer Stromschiene aus Fig. 1 bis 3.

### Ausführungsformen der Erfindung

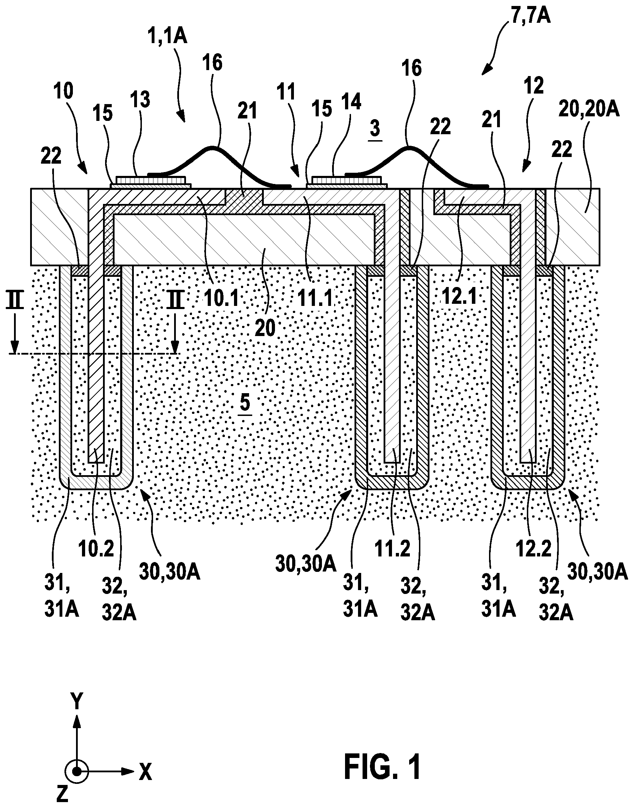

Wie aus Fig. 1 bis 5 ersichtlich ist, umfassen die dargestellten Ausführungsbeispiele einer Vorrichtung 7, 7A, 7B, 7C zur Kühlung mindestens einer Stromschiene 10, 11, 12 jeweils einen Grundkörper 20, 20A, 20B, 20C und mindestens eine Kühlrippe. Hierbei ist die mindestens eine Stromschiene 10, 11, 12 als Kühlrippe ausgebildet. Zudem ist mindestens ein Kühlkörper 30, 30A, 30B, 30C als Strömungskammer 32, 32A, 32B, 32C ausgebildet, welche eine korrespondierende Stromschiene 10, 11, 12 zumindest teilweise aufnimmt und deren Wandungen 31, 31A, 31B, 31C einen Strömungskanal bilden. Eine innerhalb der Strömungskammer 32, 32A, 32B, 32C erzwungene Fluidströmung nimmt Wärmenergie von der in die Strömungskammer 32, 32A, 32B, 32C ragenden Oberfläche der als Kühlrippe ausgebildeten Stromschiene 10, 11, 12 auf und führt die Wärmeenergie ab.

Zur Erzeugung bzw. Erzwingung der Fluidströmung innerhalb der Strömungskammer 32, 32A, 32B, 32C kann beispielsweise mindestens ein nicht dargestelltes Gebläse und/oder eine natürliche Konvektion verwendet werden.

Wie aus Fig. 1 bis 3 weiter ersichtlich ist, umfassen die dargestellten Ausführungsbeispiele der Leistungsschaltungen 1, 1A, 1B, 1C jeweils mindestens einen Leistungshalbleiter 13, 14 und mindestens zwei Stromschienen 10, 11, 12, welche unterschiedliche elektrische Potentiale aufweisen, und eine Vorrichtung 7, 7A, 7B, 7C zur Kühlung von mindestens einer Stromschiene 10, 11, 12. Hierbei ragen die als Kühlrippen ausgebildeten mindestens zwei Stromschienen 10, 11, 12 vereinzelt und galvanisch getrennt zumindest teilweise in jeweils einen als Strömungskammer 32, 32A, 32B, 32C ausgebildeten Kühlkörper 30, 30A, 30B, 30C hinein.

Wie aus Fig. 1 bis 3 weiter ersichtlich ist, sind die dargestellten Ausführungsbeispiele einer Leistungsschaltung 1, 1A, 1B, 1C jeweils als B2-Brücke ausgeführt, welche ein Paar in Reihe geschalteter als Leistungstransistoren ausgeführte Leistungshalbleiter 13, 14 umfasst, an deren Mittenabgriff bzw. Gate eine pulsweitenmodulierte Phasenspannung beispielsweise zur Speisung einer induktiven Last erregt wird. Die Anschlussverbindungen der B2-Brücke an eine Spannungsversorgung oder den Zwischenkreises eines Pulswechselrichters sind nicht dargestellt. Die Stromschienen 10, 11, 12 weisen in den dargestellten Ausführungsbeispielen jeweils zwei Schenkel 10.1, 10.2, 11.1, 11.2, 12.1, 12.2 auf. Hierbei ist ein erster Schenkel 10.1, 11.1, 12.1 der jeweiligen Stromschiene 10, 11, 12 in den Grundkörper 20, 20A, 20B, 20C der Kühlvorrichtung 7, 7A, 7B, 7C eingebettet und verläuft parallel zu einer Aufbauebene der Leistungsschaltung 1, 1A, 1B, 1C in einem Schaltungsraum 3. Der Schaltungsraum 3 liegt in der Darstellung oberhalb des Grundkörpers 20, 20A, 20B, 20C und wird von einem nicht dargestellten Gehäuse begrenzt. Ein zweiter Schenkel 10.2, 11.2, 12.2 der jeweiligen Stromschiene 10, 11, 12 ist als Kühlrippe senkrecht zum ersten Schenkel 10.1, 11.1, 12.1 ausgebildet und ragt in den korrespondierenden als Strömungskammer 32, 32A, 32B, 32C ausgebildeten Kühlkörper 30, 30A, 30B, 30C hinein. Die Kühlkörper 30, 30A, 30B, 30C erstrecken sich in eine Außenströmung 5, welche die Leistungsschaltung 1, 1A, 1B, 1C unterhalb des Grundkörpers 20, 20A, 20B, 20C umgibt und die aus den Strömungskammern 32, 32A, 32B, 32C austretenden Kühlströmungen mitsamt der darin aufgenommenen Abwärme aufnimmt.

Wie aus Fig. 1 bis 3 weiter ersichtlich ist, ist ein erster Anschluss des mindestens einen Leistungshalbleiters 13, 14 direkt mit dem ersten Schenkel 10.1, 11.1 einer der Stromschiene 10, 11, 12 verbunden. Ein zweiter Anschluss des mindestens einen Leistungshalbleiters 13, 14 ist über einen Bonddraht 16 mit dem ersten Schenkel 11.1, 12.1 einer anderen Stromschiene 10, 11, 12 verbunden. Hierbei sind eine erste Stromschiene 10 mit einem ersten elektrischen Potential, eine zweite Stromschiene 11 mit einem zweiten elektrischen Potential und eine dritte Stromschiene 12 mit einem dritten elektrischen Potential verbunden. Für die dargestellte Ausführung der Leistungsschaltung 1, 1A, 1B, 1C als B2-Brücke ist die erste Stromschiene 10 mit einem Lowside-Potential einer Festspannungsquelle oder eines Zwischenkreises eines Pulswechselrichters verbunden. An der zweiten Stromschiene 11 ist ein Phasenpotential der B2-Brücke abgreifbar, und die dritte Stromschiene 12 ist mit einem Highside-Potential der Festspannungsquelle oder des Zwischenkreises des Pulswechselrichters verbunden. Zudem ist in den dargestellten Ausführungsbeispielen der Drain- oder Kollektoranschluss eines ersten als Leistungstransistor ausgeführten Leistungshalbleiters 13 über eine Lötschicht 15 direkt mit dem ersten Schenkel 10.1 der ersten Stromschiene 10 verbunden ist, und ein Source- oder Emitteranschluss des als Leistungstransistor ausgeführten ersten Leistungshalbleiters 13 ist über einen Bonddraht 16 mit dem ersten Schenkel 11.1 der zweiten Stromschiene 11 verbunden. Des Weiteren ist der Drain- oder Kollektoranschluss eines als Leistungstransistor ausgeführten zweiten Leistungshalbleiters 14 über eine Lötschicht 15 direkt mit dem ersten Schenkel 11.1 der zweiten Stromschiene 11 verbunden, und ein Source- oder Emitteranschluss des als Leistungstransistor ausgeführten zweiten Leistungshalbleiters 14 ist über einen Bonddraht 16 mit dem ersten Schenkel 12.2 der dritten Stromschiene 12 verbunden.

Wie aus Fig. 1 weiter ersichtlich ist, ist der mindestens eine Kühlkörper 30, 30A im dargestellten Ausführungsbeispiel der Leistungsschaltung 1, 1A als separates Bauteil gefertigt und mit dem Grundkörper 20, 20A beispielsweise mittels Kleben oder Schrauben oder Presspassung verbunden. Der Grundkörper 20, 20A und die Strömungskammerwandungen 31, 31A des mindestens einen Kühlkörpers 30, 30A sind im dargestellten Ausführungsbeispiel aus einem elektrisch leitfähigen Material gefertigt. Die Stromschienen 10, 11, 12 sind im dargestellten ersten Ausführungsbeispiel mittels einer elektrisch isolierenden Wärmeleitkleber 21 stoffschlüssig in den elektrisch leitenden Grundkörper 20, 20A eingebettet. Mit dem jeweils als Kühlrippe ausgebildeten zweiten Schenkel 10.2, 11.2, 12.2 ragen die Stromschienen 10, 11, 12 durch entsprechende Öffnungen des Grundkörpers 20, 20A in die Strömungskammern 32, 32A der Kühlkörper 30, 30A hinein, deren Wandungen 31, 31A Strömungskanäle bilden. Die darin etwa mittels eines Gebläses in z-Richtung erzwungenen Innenströmungen überstreichen und entwärmen die in die Strömungskammern 32, 32A ragenden Oberflächen der jeweils als Kühlrippe ausgebildeten zweiten Schenkel 10.2, 11.2, 12.2 der Stromschienen 10, 11, 12. Jeder dieser zweiten Schenkel 10.2, 11.2, 12.2 ist im dargestellten Ausführungsbeispiel mittels einer wasserabweisenden Siegelschicht 22 von den unter Umständen feuchtebenetzten Wandungen 31, 31A der Strömungskammern 32, 32A getrennt. Diese Siegelschicht 22 kann beispielsweise aus einem hydrophoben Material bestehen oder eine mikrostrukturierte, wasserabstoßende Oberfläche etwa nach Art des Lotuseffekts aufweisen.

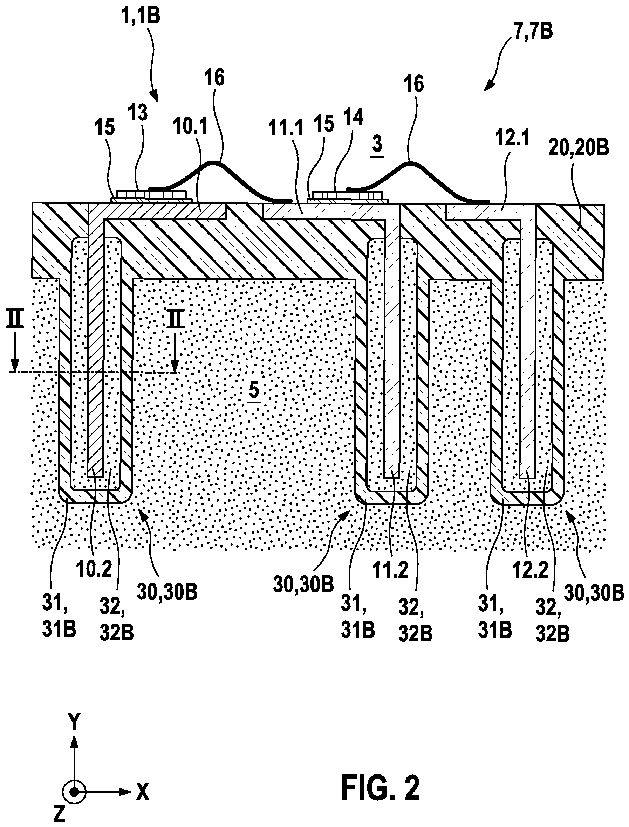

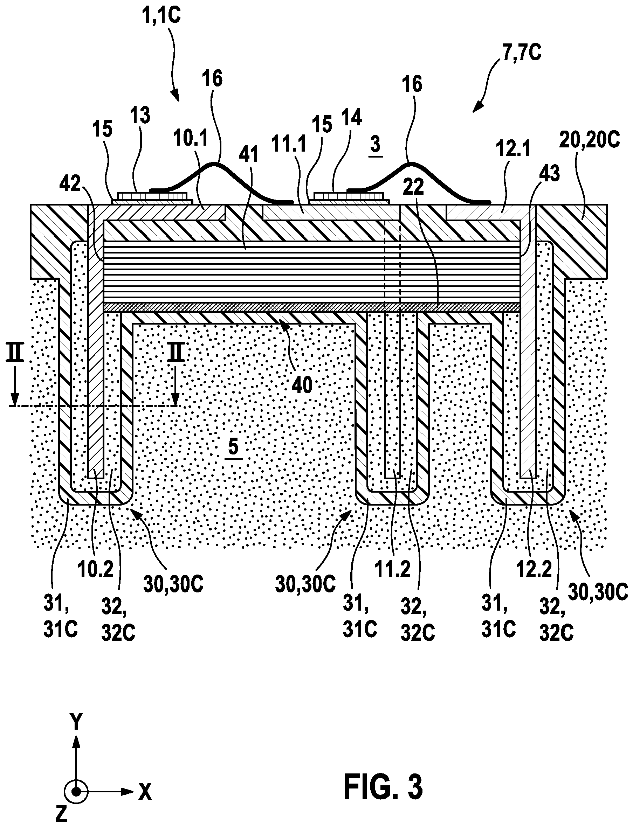

Wie aus Fig. 2 und 3 weiter ersichtlich ist, ist der mindestens eine Kühlkörper 30, 30B, 30C in den dargestellten Ausführungsbeispielen der Leistungsschaltung 1, 1B, 1C an den Grundkörper 20, 20B, 20C angeformt, dergestalt, dass die Wandungen 31, 31B, 31C der Strömungskammern 32, 32B, 32C als Bestandteile des Grundkörpers 20, 20B, 20C ausgebildet sind. Der Grundkörper 20, 20B, 20C und die Strömungskammerwandungen 31, 31B, 31C des mindestens einen Kühlkörpers 30, 30B, 30C sind im dargestellten Ausführungsbeispiel aus ein und demselben elektrisch isolierenden Material vorzugsweise aus Kunststoff gefertigt. Die Stromschienen 10, 11, 12 sind im dargestellten zweiten und dritten Ausführungsbeispiel in den Grundkörper 20, 20B, 20C eingebettet und die ersten Schenkel 10.1, 11.1, 12.1 sind vom Grundkörpermaterial stoffschlüssig umgeben. Mit dem jeweils als Kühlrippe ausgebildeten zweiten Schenkel 10.2, 11.2, 12.2 ragen die Stromschienen 10, 11, 12 in die Strömungskammern 32, 32B, 32C der Kühlkörper 30, 30B, 30C hinein, deren Wandungen 31, 31B, 31C Strömungskanäle bilden. Die darin beispielsweise mittels eines Gebläses in z-Richtung erzwungenen Innenströmungen überstreichen und entwärmen die in die Strömungskammern 32, 32B, 32C ragenden Oberflächen der als Kühlrippen ausgebildeten zweiten Schenkel 10.2, 11.2, 12.2 der Stromschienen 10, 11, 12. Durch die Anformung der Strömungskammerwandungen 31, 31B, 31C der Kühlkörper 30, 30B, 30C an den Grundkörper 20, 20B, 20C und die Verwendung des elektrisch isolierenden Materials für die Herstellung des Grundkörpers 20, 20B, 20C und der Strömungskammerwandungen 31, 31B, 31C der Kühlkörper 30, 30B, 30C ist keine weitere Siegelschicht erforderlich.

Wie aus Fig. 3 weiter ersichtlich ist, ist im dargestellten dritten Ausführungsbeispiel die zweite Stromschiene 11 gegenüber der ersten Stromschiene 10 und der dritten Stromschiene 12 in z-Richtung versetzt angeordnet und liegt daher nicht in der betrachteten x-y-Querschnittsebene. Der somit freiwerdende Bauraum zwischen dem zweiten Schenkel 10.2 der ersten Stromschiene 10 und dem zweiten Schenkel 12.2 der dritten Stromschiene 12 wird für einen Hohlraum verwendet, welcher einen Elektrodenstapel 41 eines ungehäusten Folienkondensators 40 aufnimmt. Eine als impedanzarme Schoopschicht ausgebildete erste Kontaktschicht 42 des Folienkondensators 40 schließt an den zweiten Schenkel 10.2 der ersten Stromschiene 10 an. Eine als impedanzarme Schoopschicht ausgebildete zweite Kontaktschicht 43 des Folienkondensators 40 schließt an den zweiten Schenkel 12.2 der dritten Stromschiene 12 an. Zudem ist eine Siegelschicht 22 vorgesehen, welche den Elektrodenstapel 41 von den Strömungskammern 32, 32C abtrennt. Der Folienkondensator kann beispielsweise als Zwischenkreiskapazität eines Pulswechselrichters eingesetzt werden. Die Verbindung zwischen der jeweiligen elektrischen Kontaktschicht 42, 43 und dem korrespondierenden zweiten Schenkel 10.2, 12.2 kann beispielsweise mittels Schweißen oder Löten hergestellt werden. Die ohmsche Verlustleistungsdichte im Elektrodenstapel 41 ist unmittelbar an den Kontaktflächen 42, 43 am größten. Folglich fließt die Wärme des Elektrodenstapels 41 mit geringem thermischem Widerstand in die zweiten Stromschienenschenkel 10.2, 12.2, an deren Oberflächen sie von den Fluidströmungen in den Strömungskammern 32, 32C abgetragen wird. Die Siegelschicht 22 schützt den Elektrodenstapel 41 vor Luftfeuchtigkeit und anderen schädigenden Umwelteinflüssen.

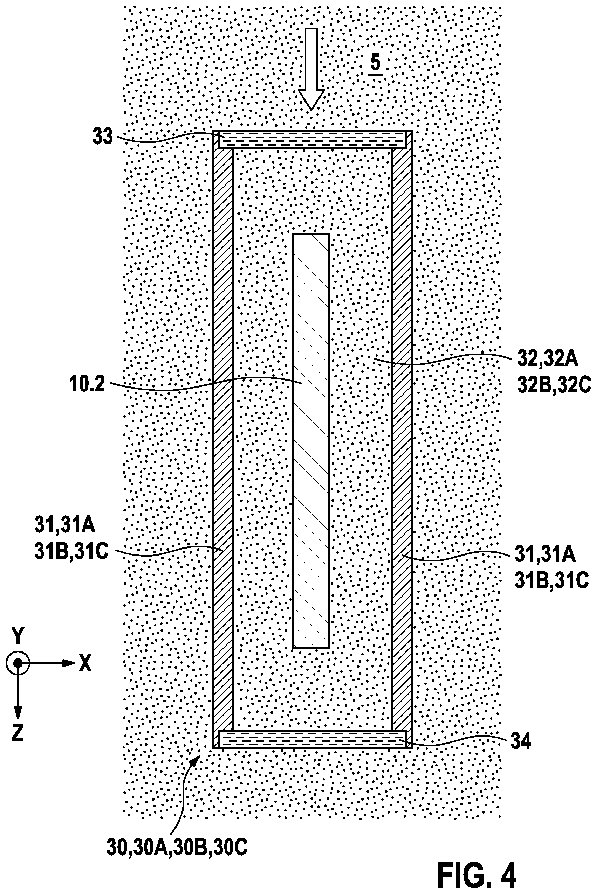

In Fig. 4 ist eine Schnittdarstellung II-II einer ersten Ausführungsform eines als Strömungskammer 32, 32A, 32B, 32C ausgeführten Kühlkörpers 30, 30A, 30B, 30C mit den Wandungen 31, 31A, 31B, 31C des Strömungskanals und des in die Strömungskammer 32, 32A, 32B, 32C hineinragenden als Kühlrippe ausgebildeten zweiten Schenkels 10.1 der ersten Stromschiene 10 dargestellt. Die weiteren Strömungskammern 32, 32A, 32B, 32C und die in die Strömungskammern 32, 32A, 32B, 32C hineinragenden zweiten Schenkel 11.2, 12.2 der zweiten und dritten Stromschiene 11, 12 sind entsprechend ausgeführt. Die Schnittebene liegt parallel zur inneren Fluidströmung, deren Richtung durch einen Blockpfeil dargestellt ist. Wie aus Fig. 4 weiter ersichtlich ist, weist jede Strömungskammer 32, 32A, 32B, 32C eine stromaufwärts gelegene Eintrittsöffnung sowie eine stromabwärts gelegene Austrittsöffnung auf. Diese beiden Öffnungen sind im dargestellten Ausführungsbeispiel mit Tropfenabscheidern 33, 34 versehen, wie sie beispielsweise von elektronischen Heißfilmluftmassenmessern (HFM) bekannt sind. Dadurch kann die Ausbildung zusammenhängender, elektrisch leitfähiger Rinnsale aus niedergeschlagenen (salzhaltigen) Flüssigkeitstropfen entlang der Wandungen 31, 31A, 31B, 31C und damit elektrische Nebenschlüsse zwischen den Stromschienen 10,11, 12 von Strömungskammer 32, 32A, 32B, 32C zu Strömungskammer 32, 32A, 32B, 32C verhindert werden.

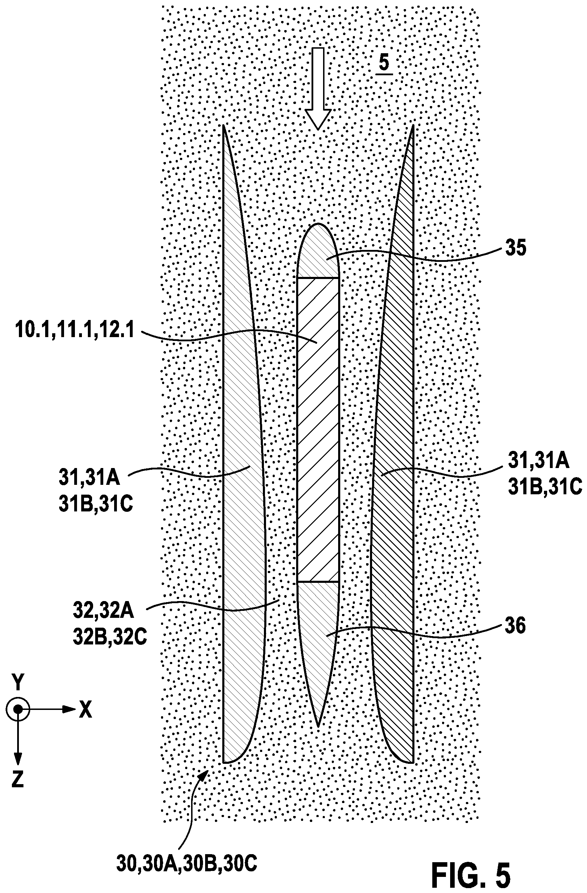

In Fig. 5 ist eine Schnittdarstellung II-II einer alternativen zweiten Ausführungsform eines als Strömungskammer 32, 32A, 32B, 32C ausgeführten Kühlkörpers 30, 30A, 30B, 30C mit den Wandungen 31, 31A, 31B, 31C des Strömungskanals und des in die Strömungskammer 32, 32A, 32B, 32C hineinragenden als Kühlrippe ausgebildeten zweiten Schenkels 10.1 der ersten Stromschiene 10 dargestellt. Die weiteren Strömungskammern 32, 32A, 32B, 32C und die in die Strömungskammern 32, 32A, 32B, 32C hineinragenden zweiten Schenkel 11.2, 12.2 der zweiten und dritten Stromschiene 11, 12 sind entsprechend ausgeführt. Die Schnittebene liegt ebenfalls parallel zur inneren Fluidströmung, deren Richtung durch einen Blockpfeil dargestellt ist. Wie aus Fig. 5 weiter ersichtlich ist, weist die Strömungskammer 32, 32A, 32B, 32C profilierte Wandungen 31, 31A, 31B, 31C auf, welche eine stetige Verjüngung des Strömungskanals bewirken und somit die Fluidströmung zur Hinterkante des zweiten Stromschienenschenkels 10.2 hin beschleunigen, um den reibungsbedingten Impulsverlust auszugleichen und die Ablösung der oberflächennahen Laminarströmung von der Stromschienenoberfläche zu vermeiden. Die Vorder- und Hinterkanten des in die Strömungskammer 32, 32A, 32B, 32C hineinragenden als Kühlrippe ausgebildeten zweiten Stromschienenschenkels 10.2, 11.2, 12.2 sind zudem mit aerodynamisch widerstandsarmen Verdrängungskörpern 35, 36 aus Kunststoff verkleidet, welche eine weitgehend laminare Umströmung der Stromschienenoberfläche bewirken. Die Ablösung der laminaren Grenzschicht kommt erst nahe der Hinterkante des stromabwärts liegenden Verdrängungskörpers 36 zustande. Dadurch bilden sich in der wandnahen Fluidströmung eine gleichmäßig dünne turbulent-viskose Grenzschicht und ein höherer Wärmestrom in die Fluidströmung als bei stumpfen Kanten aus. Die Verdrängungskörper 35, 36 bestehen etwa aus thermoplastischem Kunststoff und werden vorzugsweise in einem Spritzgießverfahren auf die Vorder- und Hinterkante der zweiten Stromschienenschenkel 10.2 ,11.2, 12.2 stoffschlüssig aufgebracht. In vorteilhafter Weise werden die Verdrängungskörper 35, 36 zusammen mit den Wandungen 31, 31A, 31B, 31C im selben Fertigungsschritt hergestellt.

Ausführungsformen der vorliegenden Erfindung ermöglichen die Entwärmung von Stromschienen, Leistungshalbleitern, Drosseln, Kondensatoren und anderer verlustleistungsbehafteter Bauelemente in leistungselektronischen Schaltungen bzw. Steuergeräten, die mittels erzwungener Luftkonvektion entwärmt werden können. Zudem wird die Aufgabe der Spreizung und Ableitung der Abwärme von Leistungshalbleitern, Drosseln und weiterer Bauelemente mit hoher Verlustleistungsdichte, insbesondere im Fall hochfrequenter elektrischer Lastprofile gelöst. Zudem verringern Ausführungsformen der Erfindung die elektrische Impedanz (ohmscher Widerstand, Eigen- und Streuinduktivität) und Verlustleistung der leistungselektronischen Aufbau- und Verbindungsglieder der Leistungsschaltung bzw. des Steuergeräts in einem weiten Frequenzbereich.

## Patentansprüche

1. Vorrichtung (7, 7A, 7B, 7C) zur Kühlung mindestens einer Stromschiene (10, 11, 12), mit einem Grundkörper (20, 20A, 20B, 20C) und mindestens einer Kühlrippe, wobei die mindestens eine Stromschiene (10, 11, 12) als Kühlrippe ausgebildet ist, wobei mindestens ein Kühlkörper (30, 30A, 30B, 30C) als Strömungskammer (32, 32A, 32B, 32C) ausgebildet ist, welche eine korrespondierende Stromschiene (10, 11, 12) zumindest teilweise aufnimmt und deren Wandungen (31, 31A, 31B, 31C) einen Strömungskanal bilden, wobei eine innerhalb der Strömungskammer (32, 32A, 32B, 32C) erzwungene Fluidströmung Wärmenergie von der in die Strömungskammer (32, 32A, 32B, 32C) ragenden Oberfläche der als Kühlrippe ausgebildeten Stromschiene (10, 11, 12) aufnimmt und abführt, **dadurch gekennzeichnet, dass** an einer stromaufwärts angeordneten Eintrittsöffnung und/oder an einer stromabwärts angeordneten Austrittsöffnung der mindestens einen Strömungskammer (32, 32A, 32B, 32C) ein Tropfenabscheider (33, 34) angeordnet ist, und/oder die Wandungen (31, 31A, 31B, 31C) der mindestens einen Strömungskammer (32, 32A, 32B, 32C) profiliert ausgeführt sind und entlang der Stromschiene (10, 11, 12) eine stetige Verjüngung des Strömungskanals bewirken und die Fluidströmung zur Hinterkante der Stromschiene (10, 11, 12) beschleunigen.

2. Vorrichtung nach Anspruch 1, **dadurch gekennzeichnet, dass** mindestens ein Gebläse und/oder eine natürliche Konvektion die Fluidströmung innerhalb der Strömungskammer (32, 32A, 32B, 32C) erzwingt.

3. Vorrichtung nach einem der Ansprüche 1 und 2, **dadurch gekennzeichnet, dass** der mindestens eine Kühlkörper (30, 30A) als separates Bauteil gefertigt und mit dem Grundkörper (20, 20A) verbunden ist.

4. Vorrichtung nach einem der Ansprüche 1 und 2, **dadurch gekennzeichnet, dass** der mindestens eine Kühlkörper (30, 30B, 30C) an den Grundkörper (20, 20B, 20C) angeformt ist.

5. Vorrichtung nach einem der Ansprüche 1 bis 4, **dadurch gekennzeichnet, dass** der Grundkörper (20, 20A, 20B, 20C) und der mindestens eine Kühlkörper (30, 30A, 30B, 30C) aus einem elektrisch leitfähigen oder aus einem elektrisch isolierenden Material gefertigt sind.

6. Vorrichtung nach Anspruch 5, **dadurch gekennzeichnet, dass** die mindestens eine Stromschiene (10, 11, 12) mittels einer elektrisch isolierenden Klebemasse (21) stoffschlüssig in den elektrisch leitenden Grundkörper (20, 20A) eingebettet ist.

7. Vorrichtung nach Anspruch 5, **dadurch gekennzeichnet, dass** die mindestens eine Stromschiene (10, 11, 12) stoffschlüssig in den elektrisch isolierenden Grundkörper (20, 20B, 20C) eingebettet ist.

8. Leistungsschaltung (1, 1A, 1B, 1C, 1D) mit mindestens einem Leistungshalbleiter (13, 14) und mindestens zwei Stromschienen (10, 11, 12), welche unterschiedliche elektrische Potentiale aufweisen, und einer Vorrichtung (7, 7A, 7B, 7C) zur Kühlung mindestens einer Stromschiene (10, 11, 12), **dadurch gekennzeichnet, dass** die Vorrichtung (7, 7A, 7B, 7C) zur Kühlung mindestens einer Stromschiene (10, 11, 12) nach zumindest einem der Ansprüche 1 bis 7 ausgeführt ist, wobei die als Kühlrippen ausgebildeten mindestens zwei Stromschienen (10, 11, 12) vereinzelt und galvanisch getrennt zumindest teilweise in jeweils einen als Strömungskammer (32, 32A, 32B, 32C) ausgebildeten Kühlkörper (30, 30A, 30B, 30C) hineinragen.

9. Leistungsschaltung nach Anspruch 8, **dadurch gekennzeichnet, dass** die Stromschienen (10, 11, 12) jeweils zwei Schenkel (10.1, 10.2, 11.1, 11.2, 12.1, 12.2) aufweisen, wobei ein erster Schenkel (10.1, 11.1, 12.1) der jeweiligen Stromschiene (10, 11, 12) in den Grundkörper (20, 20A, 20B, 20C) der Kühlvorrichtung (7, 7A, 7B, 7C) eingebettet ist und parallel zu einer Aufbauebene der Leistungsschaltung (1, 1A, 1B, 1C) in einem Schaltungsraum (3) verläuft.

10. Leistungsschaltung nach Anspruch 9, **dadurch gekennzeichnet, dass** ein zweiter Schenkel (10.2, 11.2, 12.2) der jeweiligen Stromschiene (10, 11, 12) als Kühlrippe senkrecht zum ersten Schenkel (10.1, 11.1, 12.1) ausgebildet ist und in die korrespondierende Strömungskammer (32, 32A, 32B, 32C) ragt.

11. Leistungsschaltung nach Anspruch 10, **dadurch gekennzeichnet, dass** der zweite Schenkel (10.2, 11.2, 12.2) durch eine Öffnung im elektrisch leitenden Grundkörper (20, 20A) in die korrespondierende Strömungskammer (32, 32A) ragt, wobei der zweite Schenkel (10.2, 11.2, 12.2) über eine Siegelschicht (22) von den Wandungen (31, 31A) der korrespondierende Strömungskammer (32, 32A) getrennt ist.

12. Leistungsschaltung nach einem der Ansprüche 9 bis 11, **dadurch gekennzeichnet, dass** ein erster Anschluss des mindestens einen Leistungshalbleiters (13, 14) direkt mit dem ersten Schenkel (10.1, 11.1) einer der Stromschienen (10, 11, 12) verbunden ist.

13. Leistungsschaltung nach einem der Ansprüche 9 bis 12, **dadurch gekennzeichnet, dass** ein zweiter Anschluss des mindestens einen Leistungshalbleiters (13, 14) über einen Bonddraht (16) mit dem ersten Schenkel (11.1, 12.1) einer der Stromschienen (10, 11, 12) verbunden ist.

14. Leistungsschaltung nach einem der Ansprüche 8 bis 13, **dadurch gekennzeichnet, dass** eine erste Stromschiene (10) mit einem ersten elektrischen Potential, eine zweite Stromschiene (11) mit einem zweiten elektrischen Potential und eine dritte Stromschiene (12) mit einem dritten elektrischen Potential verbunden sind.

15. Leistungsschaltung nach Anspruch 14, **dadurch gekennzeichnet, dass** die erste Stromschiene (10) mit einem Lowside-Potential einer Festspannungsquelle oder eines Zwischenkreises eines Pulswechselrichters verbunden ist, und an der zweiten Stromschiene (11) ein Phasenpotential einer B2-Brücke abgreifbar ist, und die dritte Stromschiene (12) mit einem Highside-Potential der Festspannungsquelle oder des Zwischenkreises des Pulswechselrichters verbunden ist.

16. Leistungsschaltung nach Anspruch 14 oder 15, **dadurch gekennzeichnet, dass** der Drain- oder Kollektoranschluss eines ersten Leistungshalbleiters (13) über eine Lötschicht (15) direkt mit dem ersten Schenkel (10.1) der ersten Stromschiene (10) verbunden ist, und ein Source- oder Emitteranschluss des ersten Leistungshalbleiters (13) über einen Bonddraht (16) mit dem ersten Schenkel (11.1) der zweiten Stromschiene (11) verbunden ist, wobei der Drain- oder Kollektoranschluss eines zweiten Leistungshalbleiters (14) über eine Lötschicht (15) direkt mit dem ersten Schenkel (11.1) der zweiten Stromschiene (11) verbunden ist, und ein Source- oder Emitteranschluss des zweiten Leistungshalbleiters (14) über einen Bonddraht (16) mit dem ersten Schenkel (12.2) der dritten Stromschiene (12) verbunden ist.

17. Leistungsschaltung nach einem der Ansprüche 14 bis 16, **dadurch gekennzeichnet, dass** in einem Hohlraum des Grundkörpers (20, 20C) zwischen dem zweiten Schenkel (10.2) der ersten Stromschiene (10) und dem zweiten Schenkel (12.2) der dritten Stromschiene (12) ein Elektrodenstapel (41) eines ungehäusten Folienkondensators (40) angeordnet ist, dessen erste Kontaktschicht (42) an den zweiten Schenkel (10.2) der ersten Stromschiene (10) und dessen zweite Kontaktschicht (43) an den zweiten Schenkel (12.2) der dritten Stromschiene (12) anschließt, wobei eine Siegelschicht (22) den Elektrodenstapel (41) von den Strömungskammern (32, 32C) abtrennt.

## Claims

1. Device (7, 7A, 7B, 7C) for cooling at least one busbar (10, 11, 12), comprising a main body (20, 20A, 20B, 20C) and at least one cooling rib, wherein the at least one busbar (10, 11, 12) is embodied as a cooling rib, wherein at least one heat sink (30, 30A, 30B, 30C) is embodied as a flow chamber (32, 32A, 32B, 32C), which at least partly receives a corresponding busbar (10, 11, 12) and the walls (31, 31A, 31B, 31C) of which form a flow channel, wherein a fluid flow constrained within the flow chamber (32, 32A, 32B, 32C) absorbs and dissipates thermal energy from that surface of the busbar (10, 11, 12) embodied as a cooling rib which projects into the flow chamber (32, 32A, 32B, 32C), **characterized in that** a droplet separator (33, 34) is arranged at an entry opening, arranged upstream, and/or at an exit opening, arranged downstream, of the at least one flow chamber (32, 32A, 32B, 32C), and/or the walls (31, 31A, 31B, 31C) of the at least one flow chamber (32, 32A, 32B, 32C) are embodied in a profiled manner and effect a continuous tapering of the flow channel along the busbar (10, 11, 12) and accelerate the fluid flow to the rear edge of the busbar (10, 11, 12).

2. Device according to Claim 1, **characterized in that** at least one fan and/or natural convection constrain(s) the fluid flow within the flow chamber (32, 32A, 32B, 32C).

3. Device according to either of Claims 1 and 2, **characterized in that** the at least one heat sink (30, 30A) is produced as a separate component and is connected to the main body (20, 20A).

4. Device according to either of Claims 1 and 2, **characterized in that** the at least one heat sink (30, 30B, 30C) is formed integrally on the main body (20, 20B, 20C).

5. Device according to any of Claims 1 to 4, **characterized in that** the main body (20, 20A, 20B, 20C) and the at least one heat sink (30, 30A, 30B, 30C) are produced from an electrically conductive material or from an electrically insulating material.

6. Device according to Claim 5, **characterized in that** the at least one busbar (10, 11, 12) is embedded into the electrically conductive main body (20, 20A) cohesively by means of an electrically insulating adhesive compound (21).

7. Device according to Claim 5, **characterized in that** the at least one busbar (10, 11, 12) is embedded cohesively into the electrically insulating main body (20, 20B, 20C).

8. Power circuit (1, 1A, 1B, 1C, 1D) comprising at least one power semiconductor (13, 14) and at least two busbars (10, 11, 12) having different electrical potentials, and a device (7, 7A, 7B, 7C) for cooling at least one busbar (10, 11, 12), **characterized in that** the device (7, 7A, 7B, 7C) for cooling at least one busbar (10, 11, 12) is embodied according to at least one of Claims 1 to 7, wherein the at least two busbars (10, 11, 12) embodied as cooling ribs project in a separated and galvanically isolated manner at least partly into a respective heat sink (30, 30A, 30B, 30C) embodied as a flow chamber (32, 32A, 32B, 32C).

9. Power circuit according to Claim 8, **characterized in that** the busbars (10, 11, 12) each have two limbs (10.1, 10.2, 11.1, 11.2, 12.1, 12.2), wherein a first limb (10.1, 11.1, 12.1) of the respective busbar (10, 11, 12) is embedded into the main body (20, 20A, 20B, 20C) of the cooling device (7, 7A, 7B, 7C) and extends parallel to a construction plane of the power circuit (1, 1A, 1B, 1C) in a circuit space (3).

10. Power circuit according to Claim 9, **characterized in that** a second limb (10.2, 11.2, 12.2) of the respective busbar (10, 11, 12) is embodied as a cooling rib perpendicular to the first limb (10.1, 11.1, 12.1) and projects into the corresponding flow chamber (32, 32A, 32B, 32C).

11. Power circuit according to Claim 10, **characterized in that** the second limb (10.2, 11.2, 12.2) projects into the corresponding flow chamber (32, 32A) through an opening in the electrically conductive main body (20, 20A), wherein the second limb (10.2, 11.2, 12.2) is separated from the walls (31, 31A) of the corresponding flow chamber (32, 32A) by way of a sealing layer (22).

12. Power circuit according to any of Claims 9 to 11, **characterized in that** a first terminal of the at least one power semiconductor (13, 14) is directly connected to the first limb (10.1, 11.1) of one of the busbars (10, 11, 12).

13. Power circuit according to any of Claims 9 to 12, **characterized in that** a second terminal of the at least one power semiconductor (13, 14) is connected to the first limb (11.1, 12.1) of one of the busbars (10, 11, 12) by way of a bond wire (16).

14. Power circuit according to any of Claims 8 to 13, **characterized in that** a first busbar (10) is connected to a first electrical potential, a second busbar (11) is connected to a second electrical potential and a third busbar (12) is connected to a third electrical potential.

15. Power circuit according to Claim 14, **characterized in that** the first busbar (10) is connected to a lowside potential of a fixed voltage source or of a link circuit of a pulse-controlled inverter, and a phase potential of a B2 bridge is able to be tapped off at the second busbar (11), and the third busbar (12) is connected to a high-side potential of the fixed voltage source or of the link circuit of the pulse-controlled inverter.

16. Power circuit according to Claim 14 or 15, **characterized in that** the drain or collector terminal of a first power semiconductor (13) is directly connected to the first limb (10.1) of the first busbar (10) by way of a soldering layer (15), and a source or emitter terminal of the first power semiconductor (13) is connected to the first limb (11.1) of the second busbar (11) by way of a bond wire (16), wherein the drain or collector terminal of a second power semiconductor (14) is directly connected to the first limb (11.1) of the second busbar (11) by way of a soldering layer (15), and a source or emitter terminal of the second power semiconductor (14) is connected to the first limb (12.2) of the third busbar (12) by way of a bond wire (16).

17. Power circuit according to any of Claims 14 to 16, **characterized in that** an electrode stack (41) of an unpackaged film capacitor (40) is arranged in a cavity of the main body (20, 20C) between the second limb (10.2) of the first busbar (10) and the second limb (12.2) of the third busbar (12), the first contact layer (42) of said capacitor being adjacent to the second limb (10.2) of the first busbar (10) and the second contact layer (43) of said capacitor being adjacent to the second limb (12.2) of the third busbar (12), wherein a sealing layer (22) separates the electrode stack (41) from the flow chambers (32, 32C).

## Revendications

1. Dispositif (7, 7A, 7B, 7C) de refroidissement d'au moins une barre-bus (10, 11, 12), comprenant un corps de base (20, 20A, 20B, 20C) et au moins une ailette de refroidissement, l'au moins une barre-bus (10, 11, 12) étant réalisée sous la forme d'une ailette de refroidissement, au moins un dissipateur de chaleur (30, 30A, 30B, 30C) étant réalisé sous la forme d'une chambre d'écoulement (32, 32A, 32B, 32C), laquelle accueille au moins partiellement une barre-bus (10, 11, 12) correspondante et dont les parois (31, 31A, 31B, 31C) forment un canal d'écoulement, un écoulement de fluide forcé à l'intérieur de la chambre d'écoulement (32, 32A, 32B, 32C) absorbant et évacuant de l'énergie thermique de la surface faisant saillie dans la chambre d'écoulement (32, 32A, 32B, 32C) de la barre-bus (10, 11, 12) réalisée sous la forme d'une ailette de refroidissement, **caractérisé en ce qu'**un pare-gouttes (33, 34) est disposé au niveau d'une ouverture d'entrée disposée en amont et/ou au niveau d'une ouverture de sortie disposée en aval de l'au moins une chambre d'écoulement (32, 32A, 32B, 32C) et/ou les parois (31, 31A, 31B, 31C) de l'au moins une chambre d'écoulement (32, 32A, 32B, 32C) sont réalisées profilées et provoquent un rétrécissement continu du canal d'écoulement le long de la barre-bus (10, 11, 12) et accélèrent l'écoulement de fluide vers le bord arrière de la barre-bus (10, 11, 12).

2. Dispositif selon la revendication 1, **caractérisé en ce qu'**au moins une soufflante et/ou une convection naturelle force l'écoulement de fluide à l'intérieur de la chambre d'écoulement (32, 32A, 32B, 32C).

3. Dispositif selon l'une des revendications 1 et 2, **caractérisé en ce que** l'au moins un dissipateur de chaleur (30, 30A) est fabriqué en tant qu'élément structural séparé et assemblé avec le corps de base (20, 20A) .

4. Dispositif selon l'une des revendications 1 et 2, **caractérisé en ce que** l'au moins un dissipateur de chaleur (30, 30B, 30C) est formé sur le corps de base (20, 20B, 20C).

5. Dispositif selon l'une des revendications 1 à 4, **caractérisé en ce que** le corps de base (20, 20A, 20B, 20C) et l'au moins un dissipateur de chaleur (30, 30A, 30B, 30C) sont fabriqués à partir d'un matériau électriquement conducteur ou d'un matériau électriquement isolant.

6. Dispositif selon la revendication 5, **caractérisé en ce que** la barre-bus (10, 11, 12) est enrobée par fusions de matières dans le corps de base (20, 20A) électriquement conducteur au moyen d'une masse adhésive électriquement isolante (21).

7. Dispositif selon la revendication 5, **caractérisé en ce que** la barre-bus (10, 11, 12) est enrobée par fusions de matières dans le corps de base (20, 20B, 20C) électriquement isolant.

8. Circuit de puissance (1, 1A, 1B, 1C, 1D) comprenant au moins un semiconducteur de puissance (13, 14) et au moins deux barres-bus (10, 11, 12), lesquelles présentent des potentiels électriques différents, et un dispositif (7, 7A, 7B, 7C) servant au refroidissement d'au moins une barre-bus (10, 11, 12), **caractérisé en ce que** le dispositif (7, 7A, 7B, 7C) servant au refroidissement d'au moins une barre-bus (10, 11, 12) est réalisé selon au moins l'une des revendications 1 à 7, les au moins deux barres-bus (10, 11, 12), réalisées sous la forme d'ailettes de refroidissement, faisant saillie séparément et avec isolation galvanique au moins partiellement respectivement dans un dissipateur de chaleur (30, 30A, 30B, 30C) réalisé sous la forme d'une chambre d'écoulement (32, 32A, 32B, 32C).

9. Circuit de puissance selon la revendication 8, **caractérisé en ce que** les barres-bus (10, 11, 12) possèdent respectivement deux branches (10.1, 10.2, 11.1, 11.2, 12.1, 12.2), une première branche (10.1, 11.1, 12.1) de la barre-bus (10, 11, 12) respective étant enrobée dans le corps de base (20, 20A, 20B, 20C) du dispositif de refroidissement (7, 7A, 7B, 7C) et suivant un tracé parallèle à un plan d'édification du circuit de puissance (1, 1A, 1B, 1C, 1D) dans un espace de circuit (3).

10. Circuit de puissance selon la revendication 9, **caractérisé en ce qu'**une deuxième branche (10.2, 11.2, 12.2) de la barre-bus (10, 11, 12) respective est réalisée sous la forme d'une ailette de refroidissement perpendiculaire à la première branche (10.1, 11.1, 12.1) et fait saillie dans la chambre d'écoulement (32, 32A, 32B, 32C) correspondante.

11. Circuit de puissance selon la revendication 10, **caractérisé en ce que** la deuxième branche (10.2, 11.2, 12.2) fait saillie dans une ouverture dans le corps de base (20, 20A) électriquement conducteur dans la chambre d'écoulement (32, 32A) correspondante, la deuxième branche (10.2, 11.2, 12.2) étant séparée des parois (31, 31A) de la chambre d'écoulement (32, 32A) correspondante par une couche de scellement (22).

12. Circuit de puissance selon l'une des revendications 9 à 11, **caractérisé en ce qu'**une première borne de l'au moins un semiconducteur de puissance (13, 14) est reliée directement à la première branche (10.1, 11.1) de l'une des barres-bus (10, 11, 12).

13. Circuit de puissance selon l'une des revendications 9 à 12, **caractérisé en ce qu'**une deuxième borne de l'au moins un semiconducteur de puissance (13, 14) est reliée à la deuxième branche (11.1, 12.1) de l'une des barres-bus (10, 11, 12) par le biais d'un fil de connexion (16).

14. Circuit de puissance selon l'une des revendications 8 à 13, **caractérisé en ce qu'**une première barre-bus (10) est reliée à un premier potentiel électrique, une deuxième barre-bus (11) est reliée à un deuxième potentiel électrique et une troisième barre-bus (12) est reliée à un troisième potentiel électrique.

15. Circuit de puissance selon la revendication 14, **caractérisé en ce que** la première barre-bus (10) est reliée au potentiel côté bas d'une source de tension fixe ou d'un circuit intermédiaire d'un onduleur à impulsions, et un potentiel de phase d'un pont B2 peut être prélevé sur la deuxième barre-bus (11), et la troisième barre-bus (12) est reliée à un potentiel côté haut de la source de tension fixe ou du circuit intermédiaire de l'onduleur à impulsions.

16. Circuit de puissance selon la revendication 14 ou 15, **caractérisé en ce que** la borne de drain ou de collecteur d'un premier semiconducteur de puissance (13) est reliée directement à la première branche (10.1) de la première barre-bus (10) par le biais d'une couche de brasure (15), et une borne de source ou d'émetteur du premier semiconducteur de puissance (13) est reliée à la première branche (11.1) de la deuxième barre-bus (11) par le biais d'un fil de connexion (16), la borne de drain ou de collecteur d'un deuxième semiconducteur de puissance (14) étant reliée directement à la première branche (11.1) de la deuxième barre-bus (11) par le biais d'une couche de brasure (15), et une borne de source ou d'émetteur du deuxième semiconducteur de puissance (14) étant reliée à la première branche (12.2) de la troisième barre-bus (12) par le biais d'un fil de connexion (16).

17. Circuit de puissance selon l'une des revendications 14 à 16, **caractérisé en ce que** dans un espace creux du corps de base (20, 20C) entre la deuxième branche (10.2) de la première barre-bus (10) et la deuxième branche (12.2) de la troisième barre-bus (12) est disposée une pile d'électrodes (41) d'un condensateur à film (40) non mis en boîtier, dont la première couche de contact (42) se rattache à la deuxième branche (10.2) de la première barre-bus (10) et la deuxième couche de contact (43) à la deuxième branche (12.2) de la troisième barre-bus (12), une couche de scellement (22) séparant la pile d'électrodes (41) des chambres d'écoulement (32, 32C) .
